# EUROPÄISCHE PATENTSCHRIFT

(11) **EP 2 334 840 B1**
(45) Veröffentlichungstag und Bekanntmachung des Hinweises auf die Patenterteilung: **03.09.2014**
(21) Anmeldenummer: 09736391.5
(22) Anmeldetag: 23.09.2009
(51) Int. Cl.: C23C 16/04, H01L 21/00

(54) **MAGNETISCH AUF EINEM SUBSTRATHALTER GEHALTENE SCHATTENMASKE**
SHADOW MASK HELD MAGNETICALLY ON A SUBSTRATE SUPPORT
MASQUE D'OMBRE MAINTENU PAR VOIE MAGNÉTIQUE SUR UN SUPPORT DE SUBSTRAT

(30) Priorität: 24.09.2008 DE 102008037387
(43) Veröffentlichungstag der Anmeldung: 22.06.2011
(73) Patentinhaber: Aixtron SE, 52134 Herzogenrath (DE)
(72) Erfinder: GERSDORFF, Markus, 52134 Herzogenrath (DE); FRANKEN, Walter, 52249 Eschweiler (DE); OFFERMANNS, Arno, 52457 Aldenhoven (DE)
(74) Vertreter: Grundmann, Dirk
(86) Internationale Anmeldenummer: PCT/EP2009/062306
(87) Internationale Veröffentlichungsnummer: WO 2010/034733

(56) Entgegenhaltungen:
- WO-A1-2008/026524
- US-A- 4 615 781
- US-A1- 2006 148 114
- US-A1- 2006 150 910

## Beschreibung

Die Erfindung betrifft ein Verfahren zum Abscheiden lateral strukturierter Schichten auf einem auf einem Substrathalter liegenden Substrat mittels einer flächig auf der zu beschichtenden Substratoberfläche aufliegenden Schattenmaske.

Die Erfindung betrifft darüber hinaus eine Vorrichtung zum Abscheiden lateral strukturierter Schichten auf einem auf einem Substrathalter liegenden Substrat mittels einer flächig auf der zu beschichtenden Substratoberfläche aufliegenden Schattenmaske.

Die Erfindung betrifft darüber hinaus einen Substrathalter für eine derartige Vorrichtung bzw. zum Durchführen eines derartigen Verfahrens sowie eine Schattenmaske.

Bei einem Beschichtungsprozess, bei dem auf einem Substrat eine lateral strukturierte Schicht abgeschieden wird, werden die schichtbildenden Komponenten gasförmig oder in Form von Aerosolen durch ein Gaseinlassorgan in einer Prozesskammer eingeleitet. Die Prozesskammer kann in Horizontalrichtung ausgerichtet sein. Die Decke der Prozesskammer kann von einem Gaseinlassorgan ausgebildet sein. Letzteres kann duschkopfartig angeordnete Austrittsöffnungen für das Prozessgas bzw. das Aerosol ausbilden. Der Beschichtungsprozess kann im Vakuum, bei Niedrigdruck oder aber auch bei Atmosphärendruck durchgeführt werden. Um laterale Strukturen auf dem Substrat abzuscheiden, wird eine Schattenmaske verwendet. Letztere soll im direkten gleichmäßigen Flächenkontakt zur Beschichtungsfläche des Substrates liegen.

Der Erfindung liegt die Aufgabe zugrunde, Maßnahmen anzugeben, mit denen die Maske möglichst spaltfrei auf der Substratoberfläche aufliegt.

Gelöst wird die Aufgabe durch eine Weiterbildung des Verfahrens, wobei wesentlich ist; dass der Substrathalter erste magnetische Zonen und die Schattenmaske diesen ersten magnetischen Zonen örtlich zugeordnete zweite magnetische Zonen aufweist, welche ersten magnetischen Zonen vor dem Beschichten des Substrates bei auf dem Substrat aufliegender Schattenmaske in eine aktive Stellung gebracht werden, in welcher die zweiten magnetischen Zonen gegen die Substratoberfläche angezogen werden und welche zum Aufsetzen bzw. Abnehmen der Schattenmaske in eine nichtaktive Stellung gebracht werden, in welcher die auf die zweiten magnetischen Zonen wirkende Anziehungskraft vermindert ist. Des Weiteren wird die Aufgabe durch eine Weiterbildung der Vorrichtung gelöst, wobei wesentlich ist, dass der Substrathalter erste magnetische Zonen aufweist zum magnetischen Anziehen diesen ersten magnetischen Zonen örtlich zugeordnete zweite magnetische Zonen der Schattenmaske, wobei die ersten magnetischen Zonen vor dem Beschichten des Substrates bei auf dem Substrat aufliegender Schattenmaske in eine aktive Stellung bringbar sind, in welcher die zweiten magnetischen Zonen gegen die Substratoberfläche angezogen werden und welche zum Aufsetzen bzw. Abnehmen der Schattenmaske in eine nichtaktive Stellung bringbar sind, in welcher die auf die zweiten magnetischen Zonen wirkende Anziehungskraft vermindert ist.

Die Unteransprüche stellen vorteilhafte Weiterbildungen der Erfindung dar.

Im wesentlichen ist ein Verfahren bzw. eine Vorrichtung zur Durchführung des Verfahrens vorgesehen, wobei der Substrathalter eine erste magnetische Zone und die Schattenmaske eine zweite magnetische Zone aufweist. Es sind bevorzugt mehrere erste magnetische Zonen und diesen ersten magnetischen Zonen örtlich zugeordnete zweite magnetische Zonen der Schattenmaske vorgesehen. Die ersten magnetischen Zonen werden vor dem Beschichten des Substrates bei auf dem Substrat aufliegender Schattenmaske in eine aktive Stellung gebracht. In dieser aktiven Stellung werden die zweiten magnetischen Zonen der Schattenmaske gegen die Substratoberfläche angezogen. Die ersten magnetischen Zonen des Substrathalters können zum Aufsetzen bzw. Abnehmen der Schattemnaske auf die Substratoberfläche in eine nicht aktive Stellung gebracht werden. In der nicht aktiven Stellung ist die auf die zweiten magnetischen Zonen wirkende Anziehungskraft vermindert. Der Substrathalter zeichnet sich bevorzugt durch erste Magnetzonen aus, die in Aussparungen des Substrathalters liegen. Die Aussparungen können von Nuten der Substratauflagefläche des Substrathalters ausgebildet sein. In diesen Nuten können insbesondere permanentmagnetische bewegliche Elemente einliegen. Die ersten oder zweiten magnetischen Zonen können von magnetischen, insbesondere permanentmagnetischen Elementen gebildet sein und die jeweils anderen magnetischen Zonen werden bevorzugt von ferromagnetischen Elementen gebildet. Zufolge der erfindungsgemäßen Ausgestaltung erfolgt die mechanische Kontaktierung der Schattenmaske im Bereich ihrer magnetischen Zonen mittels Kraftwirkung durch permanente Magnete. Im direkten Kontakt der Schattenmaske zum Substrat wird der Schatteneffekt dabei gegen Null Mikrometer minimiert. Die Vorrichtung ermöglicht somit die Trennung einer aktiven Beschichtungsfläche gegenüber einer passiven Beschichtungsfläche. Der Substrathalter, auf dem das Substrat aufliegt, ist bevorzugt von einem Kühler ausgebildet. Es kann sich aber auch um einen geheizten Substrathalter handeln. Dann wird insbesondere wegen der Trennung der aktiven Beschichtungsfläche von der passiven Beschichtungsfläche das Substrat und insbesondere die aktive Beschichtungsfläche des Substrats temperiert. In einer bevorzugten Ausgestaltung der Erfindung sind die ersten Magnetzonen quer zur Flächennormalen der Substratauflagefläche verlagerbar, um zwischen aktiver Stellung und inaktiver Stellung hin und her verlagert zu werden. Die dem Substrathalter zugeordneten permanentmagnetischen Elemente bilden eine gitterartige Struktur und liegen in sich kreuzenden Nuten der Substrathalteroberfläche ein. Die zweiten magnetischen Zonen der Schattenmaske bilden ebenfalls eine Gitterstruktur aus, wobei die Gitterstege der Schattenmaske räumlich den Gitterstegen der permanentmagnetischen Elemente des Substrathalters zugeordnet sind. Die passive Beschichtungsfläche wird somit durch ein geschlossenes Maskenteil bedeckt und wird allenfalls mit reduzierter Beschichtungsrate im Beschichtungsprozess mitbeschichtet und ist dabei nicht temperaturkontrolliert. Die die zweiten magnetischen Zonen der Schattenmaske ausbildenden Stege werden von einem ferromagnetischen Material und insbesondere von Invar gebildet. Die magnetischen Stege des Substrathalters sind mehrteilig und voneinander getrennt ausgebildet. In einer bevorzugten Ausgestaltung bestehen diese Stege aus einem im wesentlichen einteiligen, die Form des Gitters aufweisenden Tragkörpers und einer Vielzahl vom Tragkörper gehaltenen Magnetleisten. Die Magnetleisten sind mit einem vertikalen Bewegungsspiel von ca. 0,1mm mit dem Tragkörper lose verbunden, so dass jede individuell bewegliche Magnetleiste einen Hubweg oder eine Höhenflexibilität in dieser Größe besitzt. Hierdurch können fertigungsbedingte Toleranzen ausgeglichen werden. Die Magnetleiste selbst ist ebenfalls zweiteilig. Sie besteht aus einem Permanentmagnetstreifen, der fest mit einer Unterfütterungsplatte aus Metall verbunden ist. Der Permanentmagnetstreifen kann auf die Unterfütterungsplatte aufgeklebt werden. Die Verbindung zwischen der Magnetleiste und dem Tragkörper erfolgt über Schrauben, vorzugsweise über Senkkopfschrauben, wobei der Senkkopf in einer durchmessergrößeren Aussparung die von dem Permanentmagnetstreifen gebildet ist, einliegt. Der Schaft der Schraube durchgreift dabei eine Durchtrittsöffnung des Unterfütterungsstreifens und ist in eine Gewindebohrung des Tragkörpers eingeschraubt. Der den Tragkörper ausbildende gitterartige Rahmen ist mittels eines Hubsystems mit 10µm Genauigkeit höheneinstellbar. Das Hubsystem besteht aus mindestens einer Hubvorrichtung, die auf der der Auflagefläche des Substrathalters abgewandten Seite des Substrathalters, also auf der Substrathalterrückseite angeordnet ist. Der rahmenartige Tragkörper besitzt eine Vielzahl von Hubstöβeln, die durch Öffnungen des Substrathalters hindurchragen. Auf der Substrathalterrückseite greifen die Hubvorrichtungen an diesen Stößeln an. Bei den Hubvorrichtungen kann es sich um Kurzhubpneumatikzylinder handeln. Jedem Stößel kann eine Hubeinrichtung zugeordnet sein. Der Hubzylinder ist über eine Zylinderkonsole mit einer Basisplatte verbunden. Letztere trägt den als Kühler ausgelegten Substrathalter. An den Kurzhubpneumatikzylindern befinden sich Pneumatikanschlüsse, die gegenüber der Umgebung, also gegenüber der Prozesskammer und gegenüber einem dortigen Vakuum abgedichtet sind. Die Schraube, mit der die Magnetleiste am Tragkörper befestigt ist, hat die Funktion einer Distanzschraube. Ihre Einschraubtiefe definiert den Bereich, um den sich die Magnetleiste vom Tragkörper beabstanden kann. Dieser Bereich liegt zwischen 0,1mm und 0,3mm. Des weiteren kann eine Distanzschraube im Bereich des Pneumatikzylinders vorgesehen sein, mit dem der Stößelhub eingestellt werden kann. Bevorzugt verlagert die Hubvorrichtung den Stößel und damit auch den Tragkörper anschlagbegrenzt. Der Gesamthub kann etwa 2 bis 8mm betragen. Im inaktivierten Zustand liegt der Tragkörper auf dem Boden der Aussparungen der Auflagefläche des Substrathalters. Die Magnetleiste liegt in diesem Zustand etwa 2 bis 8mm, bevorzugt 3mm unterhalb der Auflagefläche. Die Pneumatikzylinder befinden sich in diesem Zustand in einer Endanschlagsstellung. In dieser Position kann das Substrat, welches aus Glas, aus Papier oder einem anderen geeigneten Material besteht, auf die Auflagefläche des bevorzugt aus Aluminium bestehenden Substrathalters aufgelegt werden. Im Anschluss daran wird die Schattenmaske in Kontakt zur Substratoberfläche gebracht. Dies kann entweder durch Absenken der Schattenmaske oder durch Anheben des Substrathalters erfolgen. Es ist eine Justiereinrichtung vorgesehen, um die Schattenmaske derart auf dem Substrat zu positionieren, dass die aus Invar bestehenden Gitterstege, die von einem Maskenrahmen ausgehen, deckungsgleich über den Permanentmagnetstegen des Substrathalters liegen. Da die Magnetleisten bei Aufsetzen bzw. Abheben der Schattenmaske von der Substratoberfläche in einer Entferntlage zur Auflagefläche des Substrathalters gehalten werden, ist die von den Permanentmagneten der Magnetleiste auf die Maskenstege ausgeübte magnetische Anziehungskraft minimiert. Mittels der hydraulischen Hubvorrichtung wird der Tragkörper angehoben bis in eine Endanschlagsstellung. In dieser Endanschlagsstellung liegen die einzelnen Magnetleisten etwa bündig mit der Auflagefläche des Substrathalters. Die Oberfläche der Magnetleiste kann aber auch geringfügig oberhalb oder unterhalb der Auflagefläche liegen. Wegen der losen Verbindung der Magnetleiste mit dem Tragkörper kann sich die Magnetleiste trotzdem zufolge der magnetischen Anziehungskraft zum Gittersteg der Maske an die Substratunterseite andrücken. Es entsteht dann eine verglichen mit der inaktiven Stellung maximierte Magnetkraft zwischen der Magnetleiste einerseits und dem ferromagnetischen Steg der Maske. Letzterer wird von der Magnetkraft der Magnetleiste gegen die Substratoberfläche angezogen. Am Rand des Substrathalters befinden sich insgesamt vier, bevorzugt sich paarweise gegenüberliegende Spaltüberwachungssensoren zur Überwachung eines eventuellen Spaltes zwischen der Auflagefläche eines Steges der Schattenmaske und der Substratoberfläche,

Der den Substrathalter ausbildende Kühler besitzt bevorzugt zwei Kühlkreisläufe, durch die Wasser oder ein anderes geeignetes Kühlmittel mäanderförmig durch Kühlkanäle des Kühlers geleitet wird. Die Kühlkreisläufe sind so überlappend angeordnet, dass dem Eingang eines Kreislaufes der Ausgang des anderen Kreislaufes örtlich zugeordnet ist. Hierdurch werden Kühlleistungsverluste über den Kühlweg minimiert. Zusätzlich ist vorgesehen, dass sich die beiden Kühlkanäle mehrfach überkreuzen. Sie sind deshalb in unterschiedlichen Ebenen in Bezug auf die Auflagefläche angeordnet. Mit einer derartigen Kühlkreisanordnung können Temperaturdifferenzen auf der gesamten Kühleroberfläche minimiert werden. Es ist möglich, eine Temperaturhomogenität von unter 1°C über der gesamten Kühleroberfläche zu erreichen. Auch der Maskenrahmen, der aus Aluminium besteht und zwischen welchem sich die ferromagnetischen Stege der Maske befinden, kann einen eigenen, vom Kühler unabhängigen Kreislauf besitzen. Die einzelnen Kühlkreisläufe können parallel geschaltet oder seriell geschaltet werden. Bevorzugt erfolgt die Kühlung des Maskenrahmens unabhängig von der Kühlung des Substrathalters.

Zur Durchführung des Verfahrens wird ein Substrat mittels eines Substratbe- und Entladesystems in die Prozesskammer gebracht. Dabei wird der Kühler in eine Ladeposition abgesenkt. Das Substrat wird dann auf Öffnungen des Kühlers durchdringende Stifte gelegt und befindet sich zwischen Substrathalter und einer Schattenmaske, deren Stege aus Invar und deren Rahmen aus Aluminium besteht. Der Maskenrahmen liegt auf einer speziellen Maskenhalterung. Nach dem Beladen der Prozesskammer mit dem Substrat, was mit einem Roboterarm erfolgen kann, fährt der den Substrathalter ausbildende Kühler in eine obere Position direkt unter das Substrat und hebt das Substrat von den Stiften. Der Substrathalter fährt dann weiter nach oben, bis die Substratoberfläche an der Auflagefläche der Schattenmaske anliegt. Der Spalt zwischen Oberseite des Substrates und Unterseite der Maske wird mittels der Spaltüberwachungssensoren eingestellt. Zunächst wirkt nur die Gravitationskraft auf die Invarmaske, da sich die Magnetleisten in der Be- und Entladestellung in einer abgesenkten Position befinden. Der Restspalt kann in dieser Stellung 100µm erreichen, ist aber in der Regel kleiner. Mittels der Kurzhubpneumatikzylinder werden dann die Stößel angehoben und die Tragkörper um die oben genannten etwa 3mm Distanz zur Auflagefläche angehoben. Die Magnetleisten befinden sich dann in unmittelbarer Nähe zur Substratunterseite. Sie besitzen einen minimalen Abstand zu den Invarstegen der Schattenmaske und entwickeln eine ausreichende permanente Magnetkraft auf die Invarmaske. Die Anziehungskraft ist dabei so groß, dass der Restspalt zwischen Invarmaske und Substrat auf nahe Null µm minimiert wird. Nach dem Beschichtungsprozess fahren die Kurzhubzylinder wieder in die Endposition, so dass die magnetische Anziehungskraft auf die Invarstege minimiert.

Mit der zuvor beschriebenen Vorrichtung werden Substrate mit organischen Materialien beschichtet. Es handelt sich bevorzugt um eine Organic Vapor Phase Deposition (OVPD) für OLEDs bzw. SOLARs oder Display, Lighting. Die Vorrichtung eignet sich auch für die Prozesstechnologie Polymer Vapor Phase Deposition. Des Weiteren kann als Beschichtungsmaterial Para-Xylyene verwendet werden. Ferner ist die Verwendung halogenierter Substituenten für dielektrische Anwendungen und Einkapselungsanwendungen vorgesehen. Bei der Beschichtung mit Para-Xylyene Parylene C wird die Invarmaske in Flächenkontakt mit dem Substrat gebracht.

Die Erfindung betrifft auch eine Weiterbildung der Maske. Die Maskenfreischnitte, also die Zwischenräume zwischen den Maskenstegen sollen ein besonderes Kantenprofil erhalten. Das Kantenprofil ist so eingestellt, dass die Beschichtung an den Maskenausschnitten endet, und ein Unterlaufen des Beschichtungsrahmens und der Beschichtungsstege minimiert wird. Hierzu geht eine auf das Substrat zur Auflage kommende Auflagefläche der Stege spitzwinklig in eine hohle oder schräg verlaufende Seitenflanke des Steges über.

Weder die Magnetleisten noch die zu diesen korrespondierenden Invarstegen der Maske befinden sich in einem thermisch leitenden Kontakt mit dem temperierten Substrathalter. Die Magnetleisten und die zu ihnen korrespondierenden Stege der Maske sind thermisch an das Substrat gekoppelt, da sie in flächiger Anlage zum Substrat liegen. Die Wachstumsrate wird bei einer Parylene C Beschichtung von der Oberflächentemperatur maßgeblich beeinflusst. Das Wachstum ist an der passiven, von der Maske abgeschatteten Substratoberfläche geringer als auf der aktiven Oberfläche des Substrates. Die sich trotzdem auf der Invarmaske abscheidende Schicht ist dabei so dünn, dass auch ein Anwachsen und/oder Überwachsen des Parylene C Films von dem Substrat auf der Invarmaske verhindert wird. Dies führt dazu, dass beim Anheben der Maske keine Beschichtung der Substratoberfläche abgerissen oder beschädigt wird. Während die aktive, im Stegzwischemraum angeordnete Zone des Substrats zufolge der Kühlung beschichtet wird, erfolgt auf den passiven Flächen kein Wachstum. Mit dieser Vorrichtung können diverse Maskenlayoutprofile verwirklicht werden. Es sind runde, rechteckige, quadratische oder vieleckige Formen möglich. In entsprechender Weise sind dann die Gitterzwischenräume ausgebildet. Die Gitter können somit von Stegen unterschiedlicher Breite und unterschiedlicher Lateralstruktur ausgebildet sein.

In einer Weiterbildung der Erfindung ist vorgesehen, dass das Substrat mit Hilfe der Magnetleisten gegen die Auflagefläche des Substrathalters gedrückt wird. Dies ist über eine entsprechend genaue Justierung der Distanzschrauben möglich, mit denen die Magnetleisten am Tragkörper befestigt sind. Hierdurch ist ein verbesserter Kühlkontakt und eine bessere Wärmeabfuhr gewährleistet. Ferner kann zusätzlich ein Elektrostatik Chuck System vorgesehen sein, um das Substrat gegen den Substrathalter kraftzubeaufschlagen.

Ein Ausführungsbeispiel der Erfindung wird nachfolgend anhand beigefügter Zeichnungen erläutert. Es zeigen:
- Fig. 1: eine Explosionsdarstellung der wesentlichen Elemente eines Substrathalters nebst Substrat und Schattenmaske;
- Fig. 2: eine Darstellung gemäß Fig. 1, wobei das Substrat auf dem Substrathalter und die Schattenmaske auf dem Substrat aufliegt;
- Fig. 3: eine Draufsicht auf die Darstellung gemäß Fig. 2;

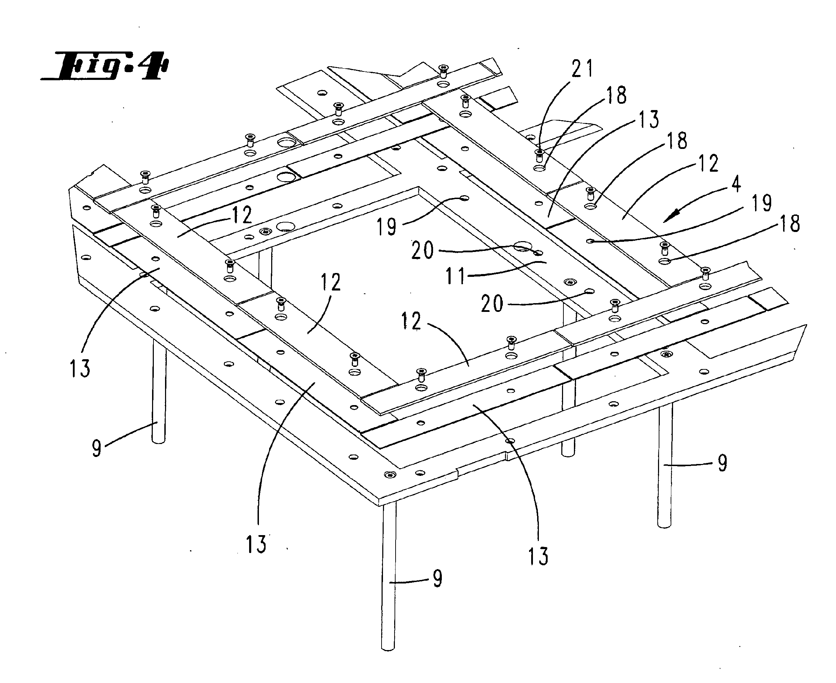

- Fig. 4: eine Explosionsdarstellung des Aufbaus der Magnetsteganordnung des Substrathalters;

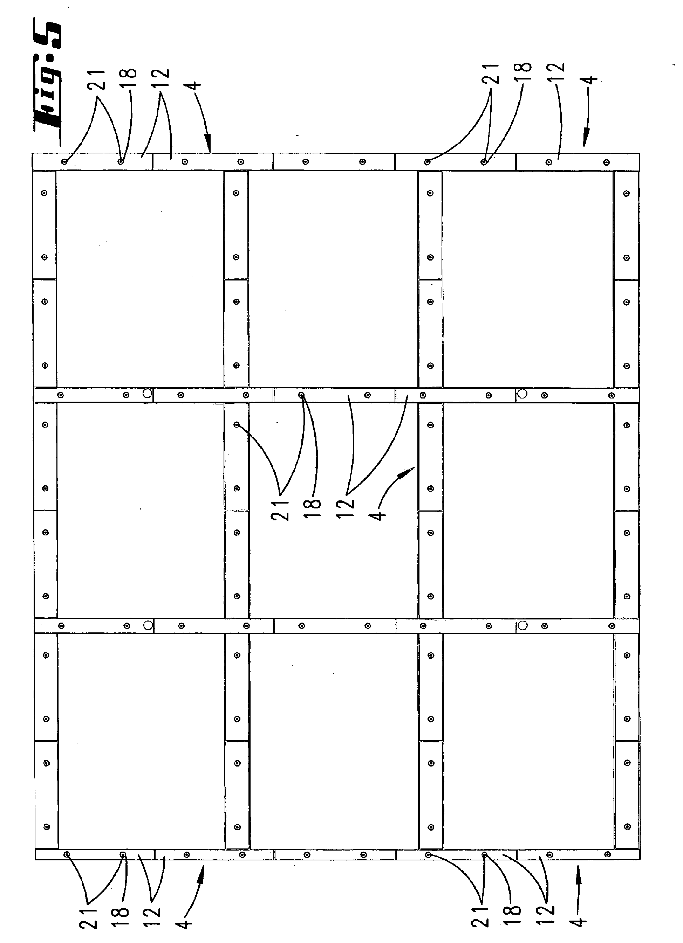

- Fig. 5: eine Draufsicht auf die Magnetsteganordnung;

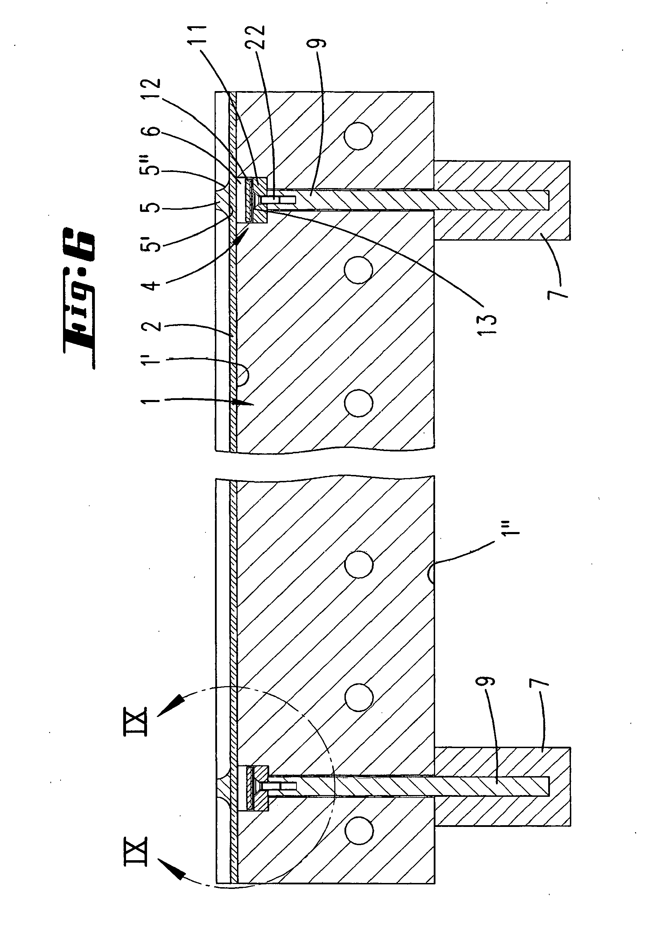

- Fig. 6: einen Schnitt gemäß der Linie VI - VI in Fig. 3;

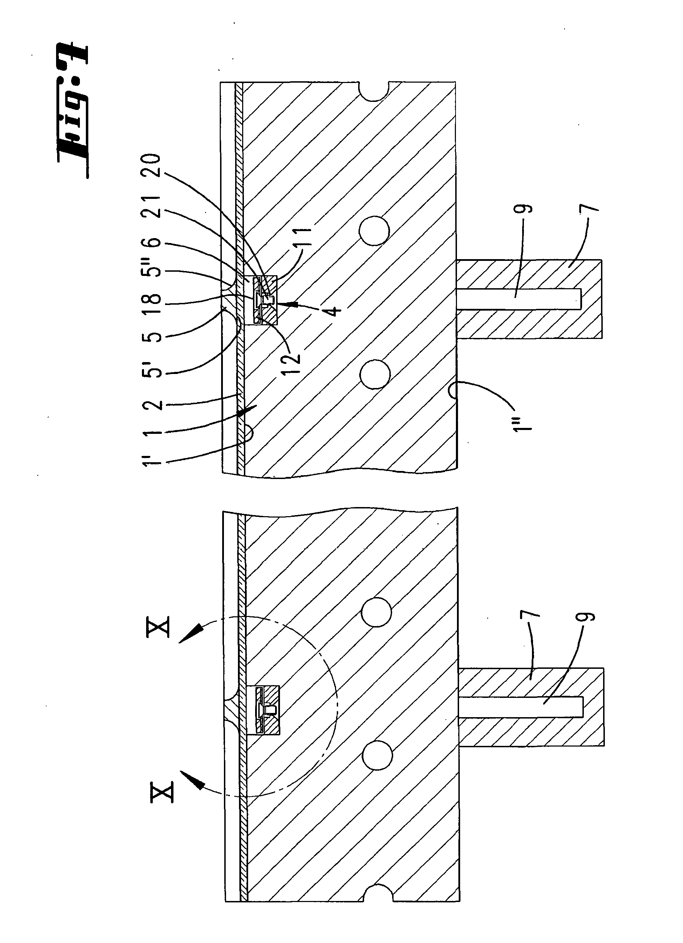

- Fig. 7: einen Schnitt gemäß der Linie VII - VII in Fig. 3;

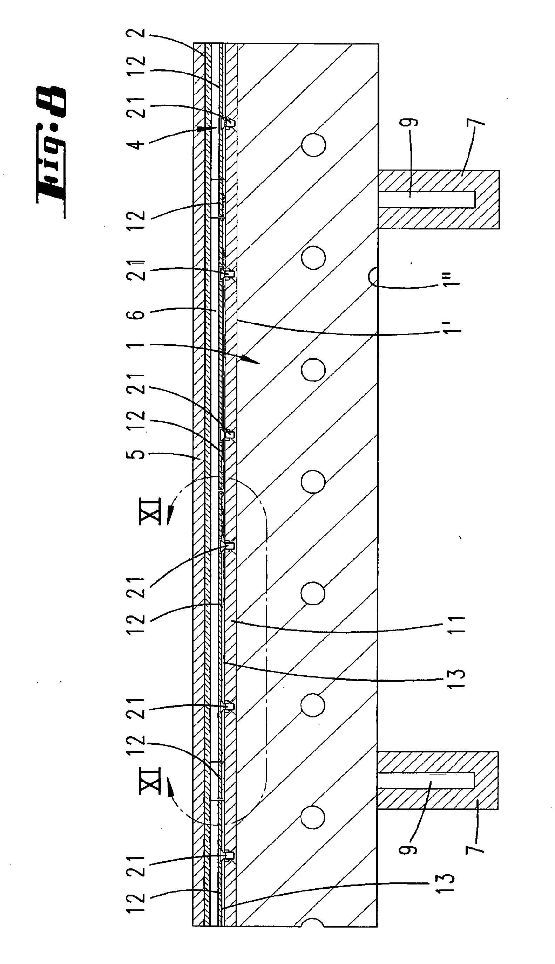

- Fig. 8: einen Schnitt gemäß der Linie VIII - VIII in Fig. 3;
- Fig. 9: einen vergrößerten Ausschnitt IX - IX in Fig. 6 in der inaktiven Betriebsstellung;
- Fig. 10: einen vergrößerten Ausschnitt X - X in Fig. 7 in der inaktiven Betriebsstellung;

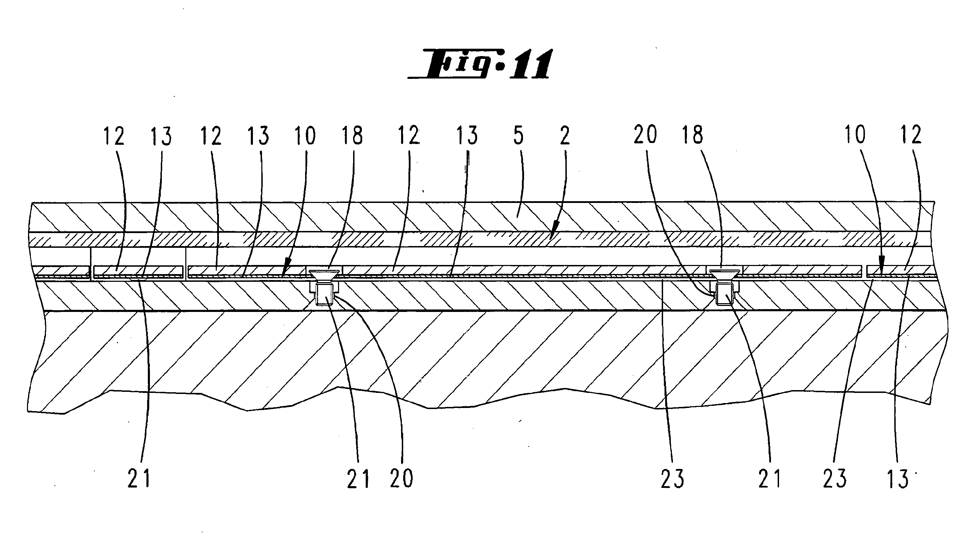

- Fig. 11: einen vergrößerten Ausschnitt XI -XI in Fig. 8 in der inaktiven Betriebsstellung;
- Fig. 12: eine Darstellung gemäß Fig. 9 in der aktiven Betriebsstellung;
- Fig. 13: eine Darstellung gemäß Fig. 10 in der aktiven Betriebsstellung;
- Fig. 14: die schematische Darstellung eines Substrathalters mit ihm zugehöriger Hubeinrichtung 24 und
- Fig. 15: grob schematisch den inneren Aufbau eines Substrathalters in einer Parallelebene zur Auflagefläche.

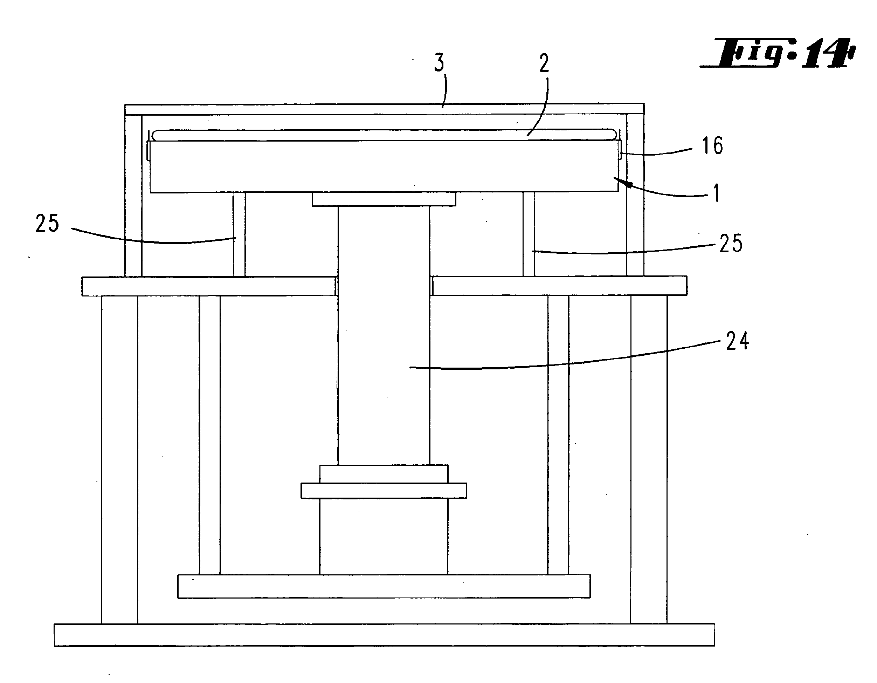

Die in Figur 14 grob schematisch dargestellte Hubeinrichtung ist innerhalb eines Reaktors angeordnet. Bei dem Reaktor handelt es sich um einen insbesondere aus Edelstahl gefertigten Behälter, in den in eine Gaszuleitung mündet. Die Gaszuleitung mündet insbesondere in ein duschkopfartig ausgebildetes Gaseinlassorgan, welches oberhalb eines Substrathalters 1 angeordnet ist. Zusammen mit einem Trägergas werden reaktive Komponenten, die gasförmig oder als Aerosole vorliegen können, in die Prozesskammer eingeleitet. Bei diesen Prekursoren kann es sich auch um Monomere oder Dimere handeln. Des Weiteren besitzt der Reaktor ein Gasauslassorgan, durch welches nicht verbrauchte Prozessgase und das Trägergas aus der Prozesskammer abgeleitet werden. Zur Erzeugung eines Vakuums oder eines Niedrigdrucksystems ist eine geregelte Vakuumpumpe vorgesehen. Der Reaktor besitzt darüber hinaus eine nicht dargestellte Ladeöffnung, durch welche eine Schattenmaske 3 bzw. ein Substrat 2 in die Prozesskammer eingebracht werden kann. Der Substrathalter 1 ist im Ausführungsbeispiel als Kühlblock aus Aluminium gestaltet und ruht auf einer Hubeinrichtung 24. Mittels der Hubeinrichtung 24 kann der Substrathalter 1 in Vertikalrichtung verlagert werden. In einer Beladestellung befindet sich der Substrathalter 1 in einer nicht dargestellten abgesenkten Stellung. Mit der Bezugsziffer 25 sind Stifte dargestellt, die durch nicht dargestellte Öffnungen durch den Substrathalter 1 hindurchragen und auf denen sich beim Absenken des Substrathalters 1 das in der Figur 14 auf dem Substrathalter 1 aufliegend dargestellte Substrat 2 ablegt. Das Substrat 2 kann in dieser auf den Stiften 25 aufliegenden Stellung entnommen werden und gegen ein anderes ersetzt werden. Die Schattenmaske 3 befindet sich in Vertikalrichtung oberhalb des Substrates und wird von einem Maskenhalter in dieser Position gehalten. Die Schattenmaske 3 verläuft parallel zum Substrat 2. Ausgehend von der in Figur 14 dargestellten Stellung kann die Hubeinrichtung 24 den Substrathalter 1 zusammen mit dem auf der Auflagefläche 1' des Substrathalters 1 aufliegenden Substrat 2 anheben, bis die Substratoberfläche 2' an die Unterfläche der Schattenmaske 3 anstößt.

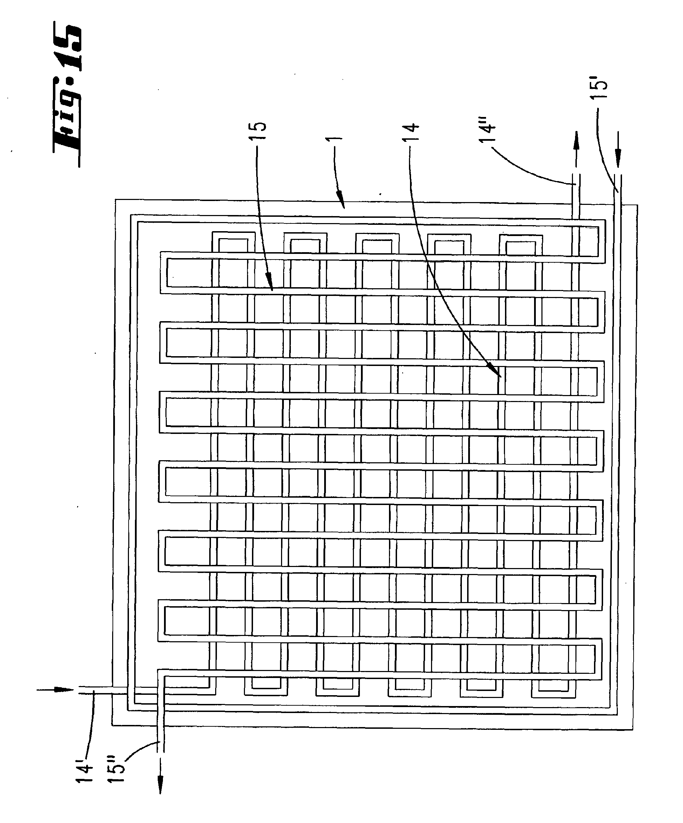

Der Figur 15 ist ebenfalls grob schematisch der innere Aufbau des Substrathalters 1 zu entnehmen. Dort sind zwei mäanderförmige Kühlkreisläufe 14,15 dargestellt. Der Eingang 14' des ersten Kühlkreislaufes 14 liegt unmittelbar benachbart neben dem Ausgang 15" des zweiten Kühlkreislaufes 15. Der Eingang 15' des zweiten Kühlkreislaufes 15 liegt unmittelbar benachbart zum Ausgang 14" des ersten Kühlkreislaufes 14. Die beiden Kühlkreisläufe 14,15 liegen jeweils in einer Parallelebene zur Substratauflagefläche 1'. Die mäanderförmig verlaufenden Kanäle der Kühlkreisläufe 14,15 kreuzen sich mehrfach.

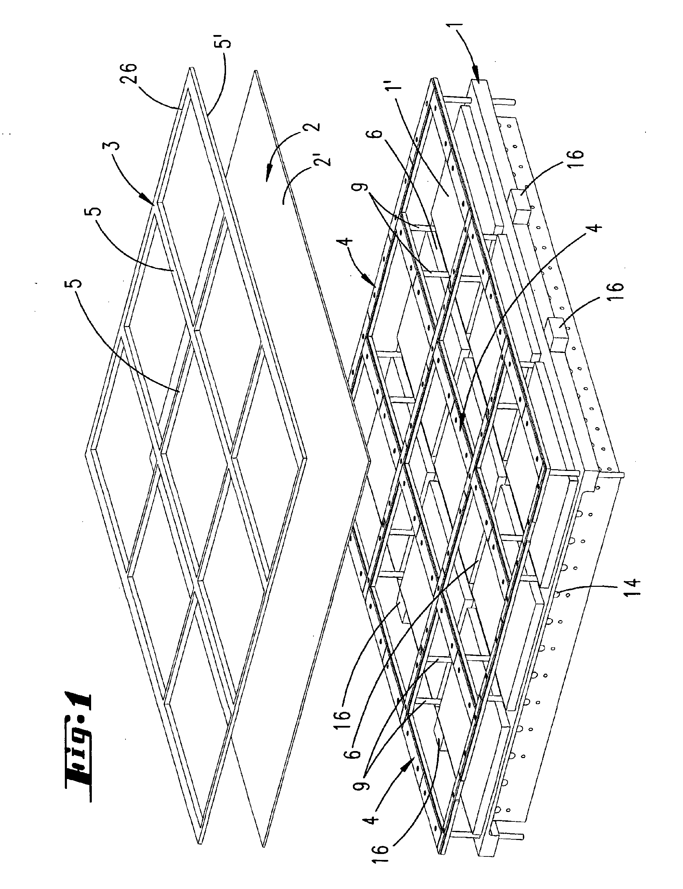

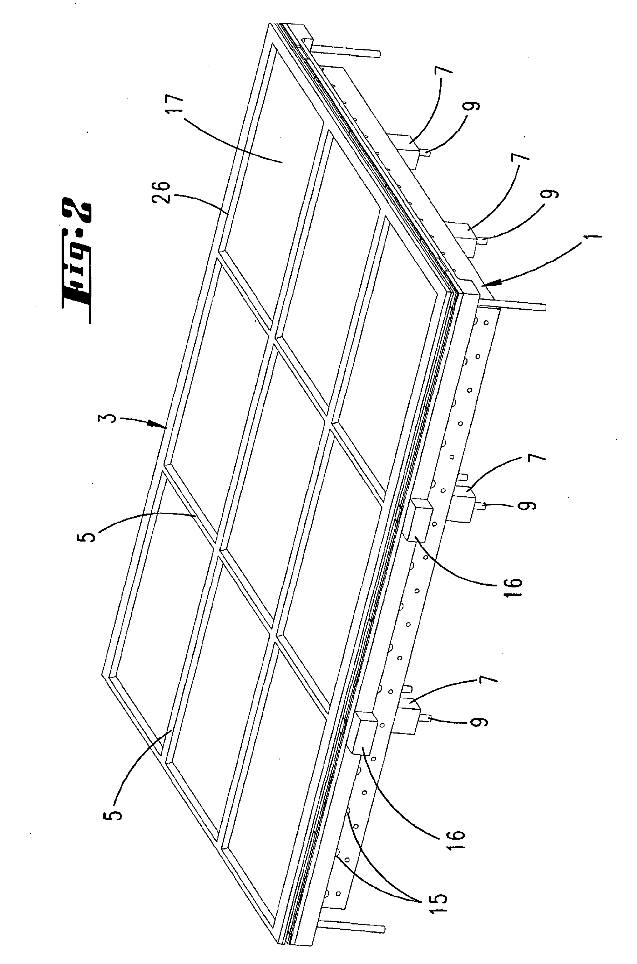

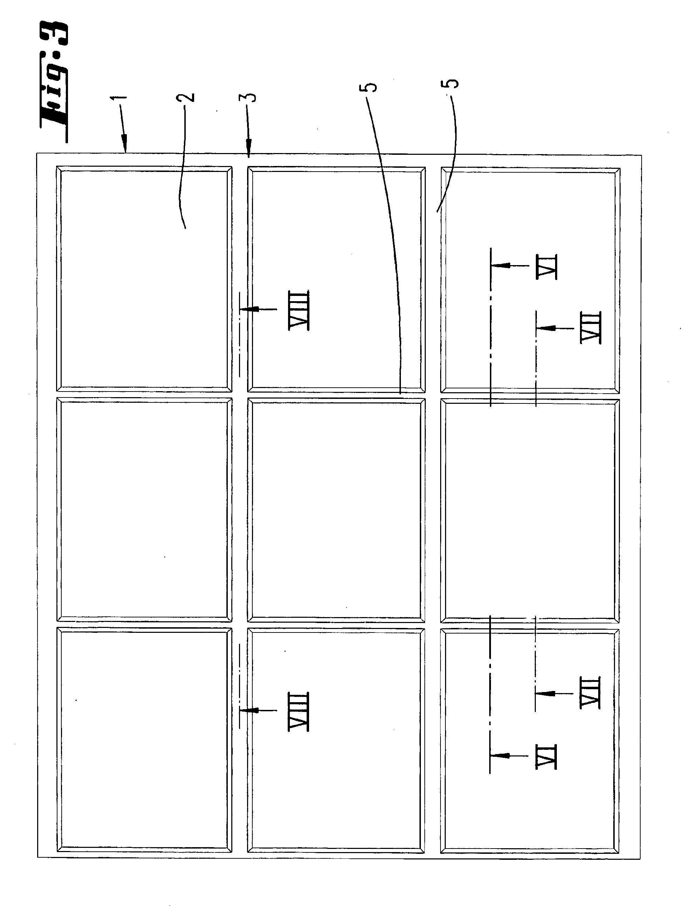

Die Figuren 1 bis 3 zeigen in verschiedenen totalen Ansichten den Aufbau der Schattenmaske 3 und der oberen Seite des Substrathalters 1.

Die Schattenmaske 3 besitzt einen Rahmen 26, der mit nicht dargestellten Kühlkanälen versehen sein kann. Dieser rechteckige Rahmen trägt insgesamt 12 Leisten, die materialeinheitlich ein Gitter 5 aus Invar, einem ferromagnetischen Material, ausbilden. Im Ausführungsbeispiel sind die Gitterzwischenräume rechteckig. In nicht dargestellten Ausführungsformen können die Gitterzwischenräume auch eine andere Gestalt aufweisen. Sie können beispielsweise rund, oval oder polygonal gestaltet sein.

Der Substrathalter 1 besteht aus einem gegebenenfalls mehrteiligen Aluminiumblock mit den oben bereits erwähnten Kühlkanälen 14,15. Die zum Substrat 2 hin weisende Auflagefläche 1' des Substrathalters 1 besitzt Aussparungen 6, die in Form von sich kreuzenden Nuten ausgebildet sind. Die kreuzenden Nuten 6 sind örtlich den Stegen 5 der Schattenmaske 3 zugeordnet.

In den Aussparungen 6 liegen Magnetleisten 10, die von einem gitterförmigen Tragkörper 11 getragen werden. Bei den Magnetleisten 10 handelt es sich um einzelne streifenförmige Objekte, die mit ein oder zwei Schrauben 21 individuelle beweglich lose mit dem Tragkörper 11 verbunden sind. Die einzelnen Magnetleisten 10 können sich geringfügig in Vertikalrichtung gegenüber dem sie tragenden Tragkörper 11 verlagern.

Der Tragkörper 11 kann aus Aluminium gefertigt sein und liegt in den Nuten 6 ein. Mittels Schrauben 22 ist der Tragrahmen 11 mit einer Vielzahl von Stößeln 9 verbunden. Hierzu besitzen die Stirnseiten der Stößel 9 Gewindebohrungen, in die die Schrauben 22 eingedreht sind. Die Stößel 9 ragen aus der Unterseite 1" des Substrathalters heraus und werden dort mit lediglich schematisch dargestellten Hubvorrichtungen 7 jeweils anschlagbegrenzt verlagert. Die Hubvorrichtungen 7 können pneumatisch betätigt werden.

Die einzelnen Magnetleisten 10 sind zweiteilig. Sie bestehen aus einem dünnen permanenten Magnetstreifen 12, der mit einem Unterfütterungsstreifen aus Blech verbunden ist. Die Verbindung kann durch einen Klebstoff erfolgen. Der Permanentmagnetstreifen 12 besitzt eine Schraubenkopfaufnahmeöffnung 18 für den Senkkopf der Einstell- und Befestigungsschraube 21. Der Schaft der Schraube 21 durchragt eine durchmessergeringere Öffnung 19 der Unterfütterungsplatte 13. Die Unterfütterungsplatte 13 wird somit vom Kopf der Schraube 21 gehalten. Die Schraube 21 ist nur lose in eine Gewindeöffnung 20 des Tragkörpers 21 eingeschraubt, so dass ein Spalt 23 zwischen der Unterseite des Unterfütterungsstreifens 13 und der Oberseite des Tragkörpers 11 verbleibt. Es ist somit ein vertikales Bewegungsspiel von einigen Zehntel Millimetern der Magnetleiste 10 gegenüber dem Tragkörper 11 gewährleistet.

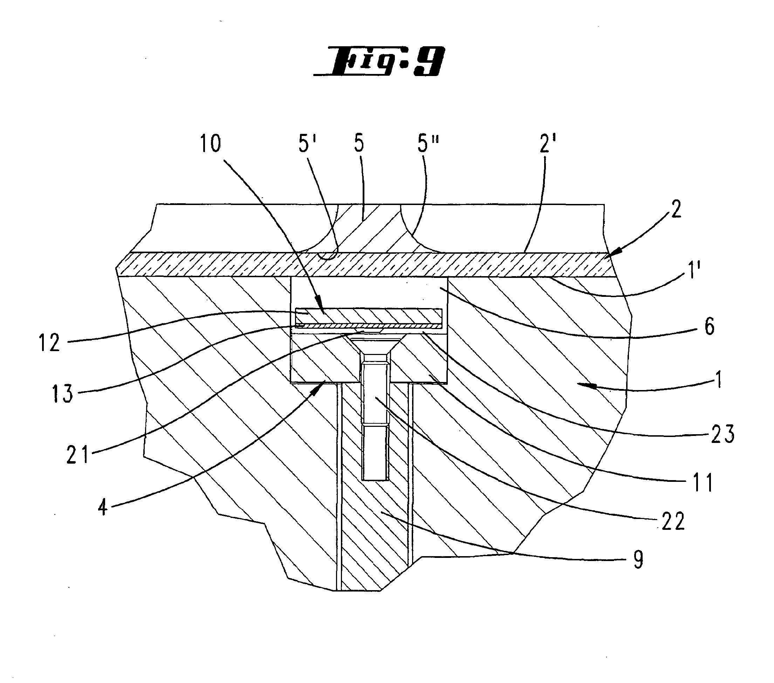

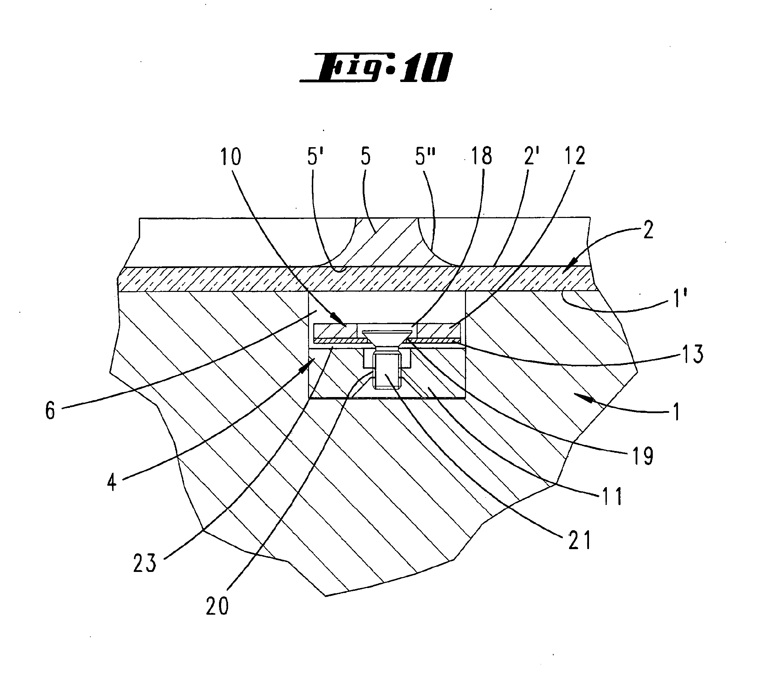

In der nicht aktivierten Stellung, die insbesondere in der Figur 10 dargestellt ist, wird der Tragkörper 11 in der Nähe des Bodens der Aussparung 6 gehalten. Dies erfolgt mittels der erwähnten Hubvorrichtung 7. In dieser Stellung besitzt die Oberfläche der Magnetleiste 10 einen Abstand von etwa 3mm zur Substratauflagefläche 1' des Substrathalters 1. Wie ferner den Figuren 9 und 10 entnommen werden kann, liegt unmittelbar oberhalb der Aussparung 6 das Substrat 2 und oberhalb des Substrates 2 der Steg 5 der Schattenmaske 3, welcher aus einem ferromagnetischen Material besteht. Die Unterseite 5' des Maskensteges 5 kann einen nicht dargestellten Abstand zur Substratoberfläche 2' besitzen.

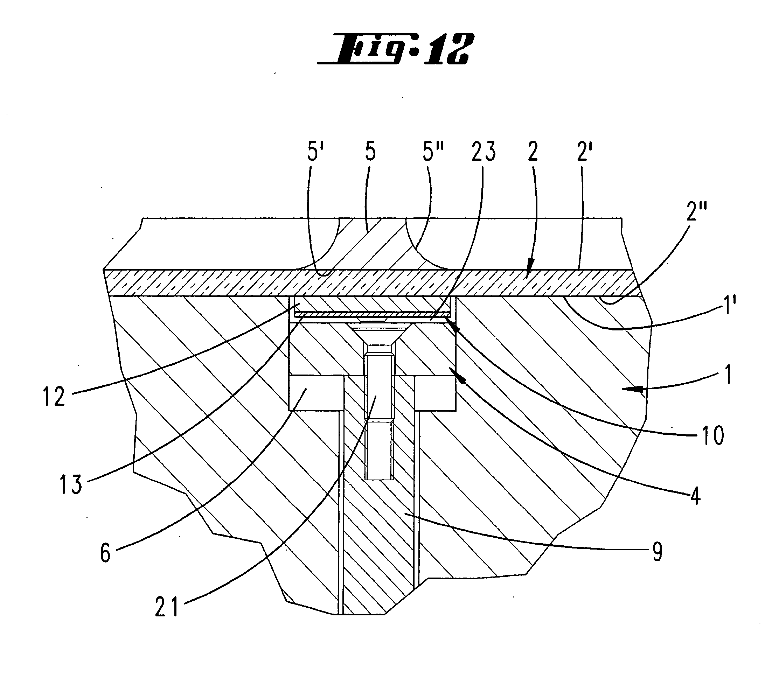

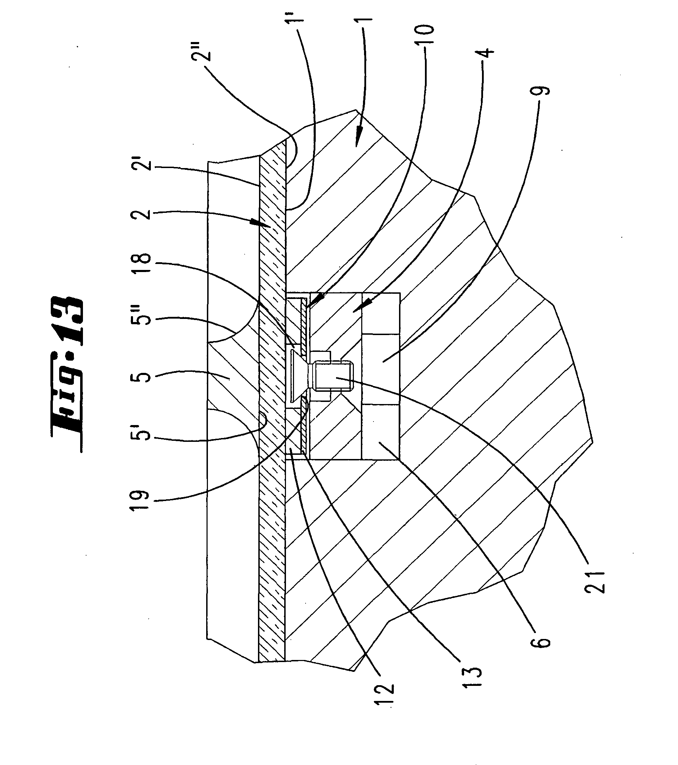

Wird nun mittels der Hubvorrichtung 7 der Tragkörper 11 angehoben bis in eine Endanschlagstellung, die insbesondere in den Figuren 12 und 13 dargestellt ist, treten die Magnetleisten 10 in berührende Anlage an die Unterseite 2" des Substrates 2. Der Figur 13 ist zu entnehmen, dass der Kopf der Schraube 21 mit einem Abstandsprofil in der Öffnung 19 des Unterfütterungsstreifens 13 einliegt. Die vom Permanentmagnetstreifen 12 ausgeübte Anziehungskraft hält die Magnetleiste 10 an der Unterseite 2" des Substrates und zieht die Auflagefläche 5' des Maskensteges 5 gegen die Oberseite 2' des Substrates 2.

Es ist vorgesehen, dass die Schraube 21 eine Einstellschraube ist, mit der die maximale Spaltweite des Spaltes 23 eingestellt werden kann. Der Spalt kann so minimiert werden, dass in der aktiven Stellung über den Kopf der Schraube 21 eine Anziehungskraft nach unten auf die Magnetleiste 10 ausgeübt wird. In diesem Falle wird mittels der Magnetleiste 10 das Substrat, also die Substratunterseite 2" gegen die Auflagefläche 1' des Substrathalters 1 gezogen. Hierdurch wird ein Wärmeaustausch optimiert.

Es ist aber auch möglich, zusätzlich eine elektrostatische Kraft mit einem ESC Electrostatic Chuck System aufzubringen.

Aus den Figuren 9,10,12 und 13 ist ferner der Querschnitt der ferromagnetischen Maskenstege 5 zu entnehmen. Die Auflagefläche 5' des Maskensteges 5 geht unter Ausbildung eines spitzen Winkels in eine hohle Seitenflanke 5" über. In einem nicht dargestellten Ausführungsbeispiel kann anstelle einer Flüssigkeitskühlung eine Kühlung mittels Peltierelementen vorgesehen sind.

## Patentansprüche

1. Vorrichtung zum Abscheiden lateral strukturierter Schichten auf einem auf einem Substrathalter (1) liegenden Substrat (2) mittels einer flächig auf der zu beschichtenden Substratoberfläche (2') aufliegenden Schattenmaske, (3), wobei der Substrathalters (1) erste magnetische Zonen (4) aufweist zum magnetischen Anziehen der diesen, ersten magnetischen Zonen (4) zugeordneten zweiten magnetischen Zonen (5) der Schattenmaske (3), wobei die ersten magnetischen Zonen (4) vor dem Beschichten des Substrates (2) bei auf dem Substrat (2) aufliegender Schattenmaske (3) in eine aktive Stellung bringbar sind, in welcher die zweiten magnetischen Zonen (5) gegen die Substratoberfläche (2') angezogen werden, und welche zum Aufsetzen bzw. Abnehmen der Schattenmaske (3) in eine nichtaktive Stellung bring-bar sind, in welcher die auf die zweiten magnetischen Zonen (5) wirkende Anziehungskraft vermindert ist, **dadurch gekennzeichnet, dass** die ersten magnetischen Zonen (4) von in Aussparungen (6) einer Substratauflagefläche (1') des Substrathalters (1) einliegenden insbesondere permanentmagnetischen Elementen gebildet sind, die den zweiten magnetischen Zonen (5) örtlich zugeordnet sind.

2. Vorrichtung nach Anspruch 1, **dadurch gekennzeichnet, dass** die ersten oder zweiten magnetischen Zonen (4,5) von magnetischen, insbesondere permanent-magnetischen Elementen gebildet sind und die jeweils anderen magnetischen Zonen (5, 4) von ferromagnetischen Elementen.

3. Vorrichtung nach einem der vorangehenden Ansprüche, **dadurch gekennzeichnet, dass** die insbesondere von (permanent-) magnetischen Elementen gebildeten ersten Magnetzonen (4) quer zur Substratauflagefläche (1') verlagerbar sind, um zwischen aktiver Stellung und inaktiver Stellung hin und her zu verlagert zu werden.

4. Vorrichtung nach einem der vorangehenden Ansprüche, **dadurch gekennzeichnet, dass** die Aussparungen (6) der Substratauflagefläche (1') von sich kreuzenden Nuten gebildet sind, in welchen die Form von Stegen eines Gitters aufweisende (permanent-) magnetische Elemente (4) einliegen, die mit ebenfalls in Form von Gitterstegen ausgebildeten ferromagnetischen Elementen (5) der Schattenmaske magnetisch zusammenwirken.

5. Vorrichtung nach einem der vorangehenden Ansprüche, **dadurch gekennzeichnet, dass** die (permanent-) magnetischen Elemente (4) des Substrathalters (1) Magnetleisten (10) sind, die mittels einer Hubvorrichtung (7) innerhalb der Aussparung (6) von einer aktiven Stellung, in welcher die Magnetleisten (4) im wesentlichen bündig zur Substratauflagefläche (1') liegen, in eine inaktive Stellung, in welcher die Magnetleisten (4) in einer Versenktstellung in den Aussparungen (6) liegen, verlagerbar sind.

6. Vorrichtung nach Anspruch 5, **dadurch gekennzeichnet, dass** die Hubvorrichtung (7) auf der der Substratauflagefläche (1') abgewandten Seite (1") des Substrathalters (1) angeordnet ist und mittels Öffnungen (8) des Substrathalters (1) durchgreifenden Stößeln (9) an den (permanent-) magnetischen Elementen (4) angreifen.

7. Vorrichtung nach einem der vorangehenden Ansprüche, **dadurch gekennzeichnet, dass** die Magnetleisten (10) mit vertikalem Bewegungsspiel in Bezug auf die horizontal verlaufende Substratauflagefläche mit einem Tragkörper (11) verbunden sind.

8. Vorrichtung nach einem der vorangehenden Ansprüche, **dadurch gekennzeichnet, dass** die Magnetleisten (10) von permanent-magnetischen Streifen (12) gebildet sind, die mit einem Unterfütterungsstreifen (13) verbunden, insbesondere verklebt sind.

9. Vorrichtung nach einem der vorangehenden Ansprüche, **gekennzeichnet durch** Spaltüberwachungssensoren (16) zur Überwachung eines eventuellen Spaltes zwischen einer Auflagefläche (5') eines Steges (5) der Schattenmaske (3) und der Substratoberfläche (2').

10. Vorrichtung nach einem der vorangehenden Ansprüche, **dadurch gekennzeichnet, dass** der Substrathalter (1) ein Kühlkörper ist und mäanderförmig verlaufende Kühlkanäle (14,15) aufweist, wobei in zwei voneinander getrennten, parallel zur Substratauflagefläche verlaufenden Ebenen zwei getrennte Kanalsysteme (14,15) vorgesehen sind, die gegensinnig mit Kühlmitteln dürchstrümbar sind bzw. durchströmt werden.

11. Substrathalter für eine Vorrichtung nach einem der vorhergehenden Ansprüche, **gekennzeichnet durch** Aussparungen (6) in der Substratauflagefläche (1), in welche permanent-magnetische Elemente einliegen, die in Richtung der Flächennormalen zur Substratauflagefläche (1') verlagerbar sind.

12. Schattenmaske (3) zur Verwendung mit einer Vorrichtung oder einem Substrathalter nach einem oder mehreren der vorangehenden Ansprüche mit gitterartig angeordneten Stegen (5) aus einem magnetischen Werkstoff, **dadurch gekennzeichnet, dass** eine auf das Substrat (2) zur Auflage kommende Auflagefläche (5') der Stege (5) spitzwinklig in eine hohle oder schräg verlaufende Seitenflanke (5") des Steges (5) übergeht.

## Claims

1. Device for depositing laterally structured layers on a substrate (2) situated on a substrate support (1), using a shadow mask (3) lying flat on the substrate surface (2') to be coated, the substrate support (1) having first magnetic zones (4) for magnetically attracting second magnetic zones (5) of the shadow mask (3) that are associated with these first magnetic zones (4), wherein, before coating the substrate (2) and when the shadow mask (3) is lying on the substrate (2), the first magnetic zones (4) may be brought into an active position in which the second magnetic zones (5) are drawn toward the substrate surface (2'), and, for placement or removal of the shadow mask (3), the first magnetic zones may be brought into an inactive position in which the attractive force acting on the second magnetic zones (5) is reduced, **characterized in that** the first magnetic zones (4) are formed by magnetic elements, in particular permanent magnetic elements, situated in recesses (6) of a substrate bearing surface (1') of the substrate support (1), which are spatially associated with the second magnetic zones (5).

2. Device according to Claim 1, **characterized in that** the first or second magnetic zones (4, 5) are formed by magnetic, in particular permanent magnetic, elements, and the respective other magnetic zones (5, 4) are formed by ferromagnetic elements.

3. Device according to one of the preceding claims, **characterized in that** the first magnetic zones (4) which are formed in particular by (permanent) magnetic elements may be displaced transverse to the substrate bearing surface (1') in order to be moved back and forth between an active position and an inactive position.

4. Device according to one of the preceding claims, **characterized in that** recesses (6) in the substrate bearing surface (1') are formed by intersecting grooves in which (permanent) magnetic elements (4) having the shape of webs of a grid lie, the magnetic elements magnetically cooperating with ferromagnetic elements (5) of the shadow mask which are likewise provided in the form of grid webs.

5. Device according to one of the preceding claims, **characterized in that** the (permanent) magnetic elements (4) of the substrate support (1) are magnetic strips (10) which by means of a lift mechanism (7) may be displaced within the recess (6) from an active position, in which the magnetic strips (4) lie substantially flush with the substrate bearing surface (1'), to an inactive position in which the magnetic strips (4) lie in a countersunk position in the recesses (6).

6. Device according to Claim 5, **characterized in that** the lift mechanism (7) is situated on the side (1") of the substrate support (1) facing away from the substrate bearing surface (1'), and plungers (9) which pass through openings (8) in the substrate support (1) engage with the (permanent) magnetic elements (4).

7. Device according to one of the preceding claims, **characterized in that** the magnetic strips (10) are connected to a support member (11) with vertical play of motion relative to the horizontally extending substrate bearing surface.

8. Device according to one of the preceding claims, **characterized in that** the magnetic strips (10) are formed by permanent magnetic strips (12) which are connected, in particular adhesively bonded, to a lining strip (13).

9. Device according to one of the preceding claims, **characterized by** gap monitoring sensors (16) for monitoring a possible gap between a contact face (5') of a web (5) of the shadow mask (3) and the substrate surface (2').

10. Device according to one of the preceding claims, **characterized in that** the substrate support (1) is a cooling element and has meandering cooling channels (14, 15), two separate channel systems (14, 15) through which coolants flow or may flow in opposite directions being provided in two planes, separated from one another, extending parallel to the substrate bearing surface.

11. Substrate support for a device according to one of the preceding claims, **characterized by** recesses (6) in the substrate bearing surface (1') in which permanent magnetic elements, which are displaceable in the direction of the surface normals to the substrate bearing surface (1'), lie.

12. Shadow mask (3) for use with a device or a substrate support according to one or more of the preceding claims, having webs (5) made of a magnetic material which are arranged in a grid-like manner, **characterized in that** a contact face (5') of the webs (5) resting on the substrate (2) merges at an acute angle into a hollow or inclined side flank (5") of the web (5).

## Revendications

1. Dispositif pour le dépôt de couches structurées latéralement sur un substrat (2) posé sur un porte-substrat (1) au moyen d'un masque d'ombre (3) reposant à plat sur la surface (2') du substrat à recouvrir, le porte-substrat (1) présentant des premières zones magnétiques (4) pour attirer magnétiquement des deuxièmes zones magnétiques (5) du masque d'ombre (3) associées auxdites premières zones magnétiques (4), les premières zones magnétiques (4) pouvant être amenées dans une position active, avant le recouvrement du substrat (2) par le masque d'ombre (3) reposant sur le substrat (2), dans laquelle les deuxièmes zones magnétiques (5) sont attirées contre la surface du substrat (2'), lesquelles peuvent être amenées dans une position non active pour placer ou retirer le masque d'ombre (3), dans laquelle la force d'attraction agissant sur les deuxièmes zones magnétiques (5) est réduite, **caractérisé en ce que** les premières zones magnétiques (4) sont faites d'éléments, en particulier d'éléments magnétiques permanents, inclus dans des évidements (6) d'une surface d'appui du substrat (1') du porte-substrat (1), qui sont associés localement avec les deuxièmes zones magnétiques (5).

2. Dispositif selon la revendication 1, **caractérisé en ce que** les premières ou les deuxièmes zones magnétiques (4, 5) sont faites d'éléments magnétiques, en particulier d'éléments magnétiques permanents et les autres zones magnétiques respectives (5, 4) d'éléments ferromagnétiques.

3. Dispositif selon l'une des revendications précédentes, **caractérisé en ce que** les premières zones aimantées (4), en particulier faites d'éléments magnétiques (permanents), sont déplaçables transversalement à la surface d'appui du substrat (1') pour être déplacées en aller-retour entre la position active et la position inactive.

4. Dispositif selon l'une des revendications précédentes, **caractérisé en ce que** les évidements (6) de la surface d'appui du substrat (1') sont formées par des rainures se croisant, dans lesquelles sont inclus les éléments magnétiques (permanents) (4) présentant la forme de tiges d'une grille, qui coopèrent magnétiquement avec les éléments ferromagnétiques (5) également façonnés en forme de tiges de grille.

5. Dispositif selon l'une des revendications précédentes, **caractérisé en ce que** les éléments magnétiques (permanents) (4) du porte-substrat (1) sont des barres aimantées (10), qui sont déplaçables, au moyen d'un dispositif de levage (7) à l'intérieur de l'évidement (6), d'une position active, dans laquelle les barres aimantées (4) reposent de façon sensiblement ramassée sur la surface d'appui du substrat (1'), dans une position inactive, dans laquelle les barres aimantées (4) se trouvent dans une position noyée dans les évidements (6).

6. Dispositif selon la revendication 5, **caractérisé en ce que** le dispositif de levage (7) est disposée sur le côté du porte-substrat (1) opposé à la surface d'appui du substrat (1') et vient en prise avec les éléments magnétiques (permanents) (4) au moyen de poussoirs (9) pénétrant des ouvertures (8) du porte-substrat (1).

7. Dispositif selon l'une des revendications précédentes, **caractérisé en ce que** les barres aimantées (10), avec un jeu de déplacement vertical par rapport à la surface d'appui du substrat s'étendant horizontalement, sont reliées avec un corps de support (11).

8. Dispositif selon l'une des revendications, **caractérisé en ce que** les barres aimantées (10) sont faites de lames magnétiques permanentes (12), qui sont reliées, en particulier collées, avec des lames de calage (13).

9. Dispositif selon l'une des revendications précédentes, **caractérisé par** des capteurs de surveillance d'entrebâillement (16) pour surveiller un entrebâillement potentiel entre une surface d'appui (5') d'une tige (5) du masque d'ombre (3) et la surface du substrat (2') .

10. Dispositif selon l'une des revendications précédentes, **caractérisé en ce que** le porte-substrat (1) est un dissipateur thermique et présentent des canaux de refroidissement (14,15) s'étendant de façon méandreuse, où sont prévus, dans des plans séparés l'un de l'autre s'étendant parallèlement à la surface d'appui du support, deux systèmes séparés de canaux (14,15) qui peuvent être traversés, respectivement être traversés, en sens opposé par des réfrigérants.

11. Porte-substrat pour un dispositif selon l'une des revendications précédentes, **caractérisé par** des évidements (6) dans la surface d'appui de substrat (1'), dans lequel des éléments magnétiques permanents sont inclus, et qui peuvent être déplacés dans la direction de la normale à la surface d'appui de substrat (1').

12. Le masque d'ombre (3) pour l'utilisation avec un dispositif ou un porte-substrat selon l'une ou plusieurs des revendications précédentes avec des tiges (5) agencées en forme de grille en un matériau magnétique **caractérisé en ce qu'**une des surfaces d'appui (5') des tiges (5) venant en appui sur le substrat (2) passe avec un angle aigu dans un flanc latéral (5") de la tige (5), creux ou s'étendant obliquement.
